# EUROPEAN PATENT APPLICATION

(11) **EP 1 253 644 A1**
(43) Date of publication of application: **30.10.2002**
(21) Application number: 01109847.2
(22) Date of filing: 23.04.2001
(51) Int. Cl.: H01L 27/142

(54) **Electric power generating device and method of fabrication**

(71) Applicant: Fischer, Diego, Dr., 2000 Neuchâtel (CH)
(72) Inventor: Fischer, Diego, Dr., 2000 Neuchâtel (CH)
(74) Representative: Saam, Christophe

(57) **Abstract**

An electric power generating device and a method of fabrication so that a variety of different geometrical configurations and arrangements can still be realized after having applied the active power generating layer over the whole area of the service.
In a preferred embodiment, the power generating device comprises a plurality of discontinuities, such as void areas, in at least one of the layers in the device. Only a first part of the discontinuities is used for defining the boundaries and/or connections between voltage-generating sections, the remaining discontinuities are unused.

## Description

The present invention concerns an electric power generating film and a method of fabrication.

### Related Art

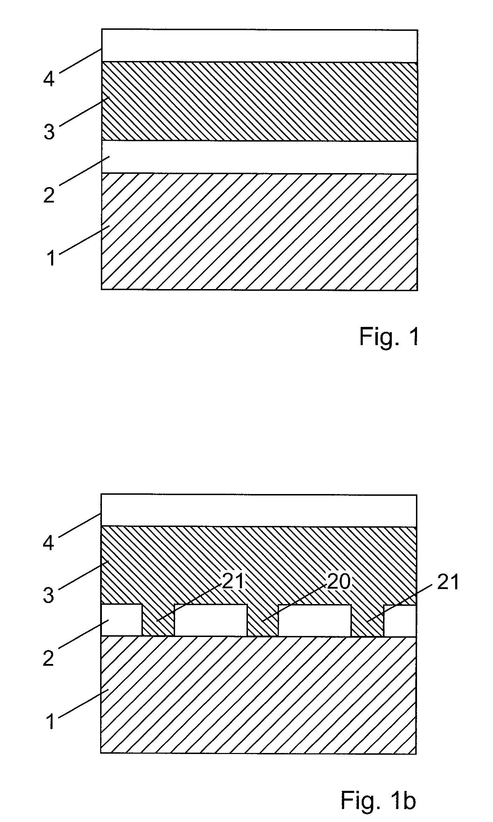

The vertical structure of a known electric power generating film is shown in Figure 1. The film comprises an isolating substrate 1 and a first conductive layer 2 extending over the substrate 1. A voltage-developing layer 3, for example a solar cell, extends over the first conductive layer 2. A second conductive layer 4 extends over the voltage-developing layer 3. The energy delivered by an external source, for example solar, electromagnetic, thermal or chemical energy, yields a transfer of electrical charges with opposite signs on both faces of the voltage-generating layer, and thus a voltage appearing between the first and second conductive layers. In the case of a solar cell, the second conductive layer 4 typically is transparent to permit solar radiation to reach the voltage-generating layer 3.

The voltage produced by a single section, however, is insufficient for most applications. To achieve a useful power level from the voltage-generating film, it is already known to divide the film into a plurality of sections and to connect the sections in series. In this context, a "section" is an elementary cell comprising a first electrode at a first potential, a second electrode at a second potential, and at least one voltage-generating layer between the two electrodes.

Connecting several sections or series of sections in parallel leads to a higher nominal current. The size and shape of each section is optimized in order to improve the efficiency and to diminish the resulting internal resistance of the voltage-generating film. The connection between sections is selected in order to produce a suitable current-voltage characteristic at the output of the film.

When the film has to be used for different applications or in different devices that request different operating voltages or voltage-current characteristics, it may be difficult to find a layout of sections and a way of interconnecting those sections that suit those different needs. It is thus usually necessary to use a supplementary circuit at the output of the film in order to adapt its characteristic, or to produce different films with different layouts of sections for different applications. Both solutions tend to be expensive. The end-user has no way of optimising the parameters defined by the film manufacturer according to his own needs.

US4892592 describes a cell array comprising a plurality of layers superimposed over a substrate. The first layer over the substrate is a conductive layer comprising a plurality of void areas. The final arrangement of the sections and the connection between the sections are entirely defined by the pattern of void areas. After the fabrication of the voltage-generating active layer, it is no longer possible to implement different geometrical arrangements or electrical connections.

Another method for fabricating solar cells is described in US4292092. The arrangement described in this document comprises a plurality of tandem junction solar cells serially connected on a substrate. Laser-processed strips in the first conducting layer over the substrate define the boundaries and connections between adjacent sections. The layout of the cell can thus only be chosen by the solar cell fabricant, and this must be made at a very early stage in the fabrication process.

US4243432 describes a method for fabricating solar cells wherein the entire surface of a substrate is covered with a plurality of layers; only those portions of each layer are removed which must be removed to form a plurality of photovoltaic sections on the substrate and to form the electrical interconnections between the sections. This process allows to define the interconnections between the sections during a post-processing process after the fabrication of the different layers. This post-processing process comprises a plurality of steps for removing selected portions of the different layers and for applying different insulating or conducting materials and is thus expensive.

Other solar cells fabrication methods are described in US4262411, US4697041 and US4042418, among others.

It is an aim of the present invention to propose an electric power generating film and a method of fabrication that is improved over the prior art systems, notably that does not have the inconveniences mentioned.

Another aim of the present invention is to propose an electric power generating film and a method of fabrication permitting the boundaries and/or connections between the sections to be defined at a very late stage of the fabrication process. Preferably, the invention aims to permit the boundaries and/or connections between the sections to be defined after the final superimposed layer is applied. Preferably, the invention enables the end-user to define himself the boundaries and/or connections between the sections.

Another aim of the present invention is to propose a semi-finished film that can be customized without the adjunction of one or several new layers, so as to define the shape and size of the sections as well as the connection between the sections.

Another aim of the present invention is to propose an electric power generating film that can be customized without requiring complex equipments, for example by means of electrical command signals, by laser or by ultra-violet radiation.

According to the invention, these aims are achieved by means of an electric power generating film and a method of fabrication having the characteristics of the independent claims, variants of preferred embodiments being moreover described in the dependent claims.

In particular, these aims are achieved by means of an electric power generating film including at least a plurality of mutually connected power-generating sections, said film comprising a plurality of superimposed layers, at least one of said layers different from the upper layer comprising a regular pattern of discontinuities, wherein only a first part of said discontinuities in said at least one layer is used for defining the boundaries and/or connections between said sections, the remaining discontinuities in said at least one layer being unused.

According to the invention, the boundaries and/or connections between the cells use discontinuities in the lower layers of the film. By appropriate selection of only part of these discontinuities, one can thus define sections of a variable shape and size and/or modify the way in which the sections are connected.

According to another independent characteristic of the invention, the number of discontinuities provided in the film is greater than the number of sections.

According to another independent characteristic of the invention, the electrical resistance of the cell increase. The resulting small power drop is overcompensated by the advantages.

An advantage of the invention is to permit the production of a variety of geometrically and electrically different power generating films based on a uniform semi-finished product.

In a preferred embodiment, this semi-finished product comprises at least one uniform substrate material, one first conductive layer having a geometrical pattern of discontinuities, for example void areas, and a voltage-generating layer extending over the whole area of the first conductive layers and over its discontinuities.

Another advantage of the invention is to permit the configuration of different electric power generating products and arrangements at a final step of fabrication (to be called "post-configuration" process), allowing rapid and just-in-time delivery of electric power generating devices while having only a limited number of semi-finished universal base products in stock. The post-configuration process can be performed after the fabrication of the voltage-generating layer in the semi-finished universal base product.

Another advantage of the invention is to reduce the fabrication cost of customized electric power generating devices, particularly in thin film solar cell devices.

### Description of the drawings

The invention will be better understood with reference to the description of an embodiment illustrated by the attached drawings containing the figures, in which:
Figure 1 shows the vertical structure of an electric power generating film;
Figure 1b shows the vertical structure of an electric power generating film in which one conductive layer comprises discontinuities (void areas) according to the invention.
Figures 2 to 4 show examples of implementations of void patterns;
Figures 5 to 7 show examples of implementations of finished cell arrangements based on the void pattern of Figure 2;
Figure 8 shows an example of implementation of a finished cell arrangement based on the void pattern of Figure 3.
Figure 8b shows an example of implementation of a finished cell arrangement based on the void pattern of Figure 4.Figure 9 shows a detail of the vertical structure of the finished cell arrangement of Figure 8b.
Figure 10 shows a detail of the vertical structure of a finished cell arrangement comprising more than two film conducting layers.
Figures 11 to 12 show examples of implementations of discontinuities comprising void patterns and switches.

### Description of the invention

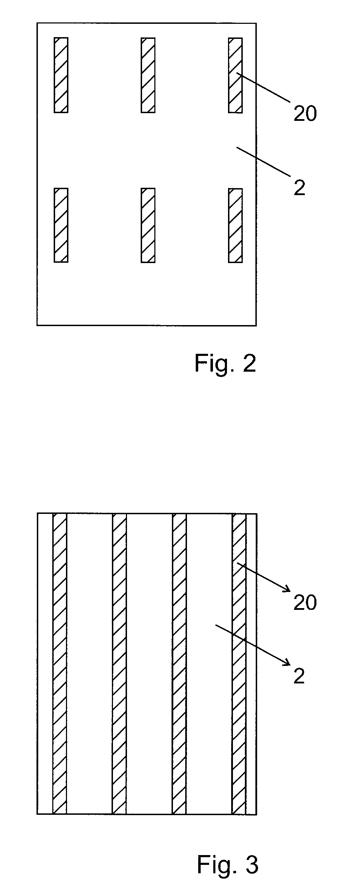

This invention will be more clearly understood by referring to Figure 1b that illustrates the vertical structure of an electric power generating film and to Figures 2 to 4 that illustrate various patterns of discontinuities in a first conductive layer according to various embodiments of the invention. The film comprises a substrate 1 of an insulating material such as glass, ceramic, polymer, etc. In a preferred embodiment, the substrate can be made of a bendable material such as a polyimide film of 50 µm thickness.

A metal, a metal alloy, a conductive transparent oxide or a combination of these is coated over the whole area to form the first conductive layer 2 ("back electrode"). According to the invention, the first conductive layer is regularly patterned with void areas 20, i.e. holes through the layer 2. The layer 2 can be deposited over the substrate 1 by evaporation of 0.1 µm Chromium or Aluminium through a wire mesh mask. The pressure before evaporating is preferably less than 10⁻⁶ mbar. Alternatively, the void areas 20 can be fabricated in the layer 2 with a mechanical or laser scribing process.

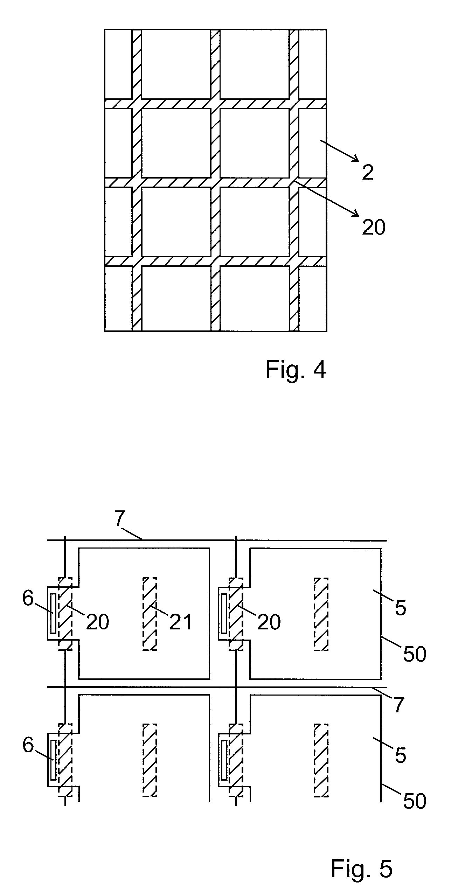

The void areas 20 can comprise isolated rectangular holes 20 of 0.1 cm² area as shown in Figure 2, lines as shown in Figure 3 or a grid as shown in Figure 4. Other patterns of discontinuities and void areas can be used within the framework of this invention.

The metallized substrate 1, 2 is then preferably washed in deionised water of a conductivity of < 10⁻¹⁰ S. This step may be omitted.

Then the active voltage-generating layer 3 is applied over the first conductive layer 2. The voltage-generating layer can comprise one or several coatings of silicon or silicon alloys coated over the whole area.

In the case of an amorphous silicon solar cell, an amorphous silicon p-i-n structure may be deposited over the first conductive layer. P-doping is obtained by adding B₂H₆ to silicon (SiH₄). N-doping is obtained by adding PH₃ to silicon and hydrogen (H₂). The three p, i and n layers may have a thickness about 100-300 Å, 2500Å and 100-200 Å respectively.

Alternatively to a p-i-n solar cell, a n-i-p solar cell might be applied to seek a higher conversion efficiency. Also, a stacked (or tandem) structure might be adopted to improve overall product performance and utility. Other voltage-generating layer may be used for converting a temperature gradient, or a chemical potential, or an electromagnetic radiation, into electricity.

A metal, a metal alloy, a conductive transparent oxide or a combination of these are coated over voltage-generating layer 3 to form the second conductive layer 4. In an embodiment, the second conductive layer may be made of indium-tin-oxide (ITO) with a thickness of about 600 Å deposited by RF-magnetron sputtering. In case of a solar cell, the second conductive layer is preferably transparent.

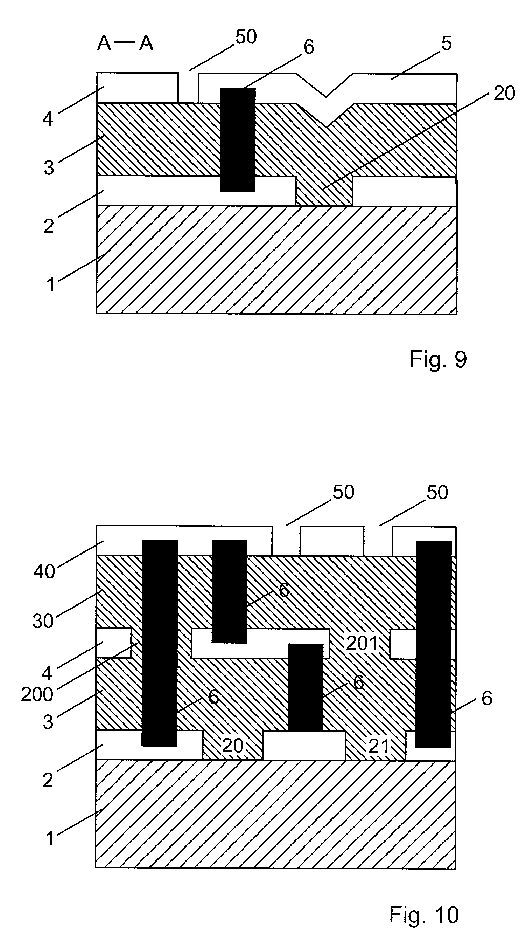

The film may comprise more layers than shown in this simple embodiment. Figure 10 shows an example in which a second voltage-generating layer 30 has been deposited over the second conductive layer 4. A third conductive layer 40 extends over the second voltage-generating layer 30. The first and second conductive layers 2, 4 each have a pattern of discontinuities, in this example void areas 20, 21 respectively 200, 201 wherein only some areas 20 respectively 200 are used for defining the layout and interconnections of sections. Other embodiments may comprise supplementary voltage-generating layers or layers for other purposes, for example antennas or control layers for controlling switches, as will be described later.

The structure obtained by the process described so far is a semi-finished electric power generating film comprising only one huge voltage-generating section extending over the whole substrate. This semi-finished product can be sold by solar-cell makers and customized by users in a post-configuration process in order to suit various needs and applications. This post-configuration process can be made in another place and with cheaper equipments or workstations than the layer deposition steps described so far.

In a first embodiment, this post-configuration process comprises steps of isolating, cutting and/or interconnecting the various layers 2, 3, 4 in order to define the boundaries between individual sections 5 and/or to choose the mutual connections between independent sections, thus defining the geometrical and electrical arrangement of sections still after the application of the active layer 3.

This post-configuration process uses only a first part of the void areas 20 for isolating adjacent sections 5, while the remaining void areas 21 remain unused and actually result in an increased series resistance of the first layer. Geometry and conductivities are however chosen in a way such that the occurred losses are very small or even negligible.

Various layouts of sections that can be defined during the post-configuration process using a semi-finished film with the void areas pattern of Figure 2 are illustrated as examples in Figures 5 to 7. Reference 20 shows the void areas of Figure 2 which are used for isolating adjacent sections, whereas unused void areas are designated with the reference number 21. The lines 7 show isolating portions cut through all layers 2 to 4. The lines 50 serve to isolate different electric nodes in the second conductive layer and define the boundaries of the sections.

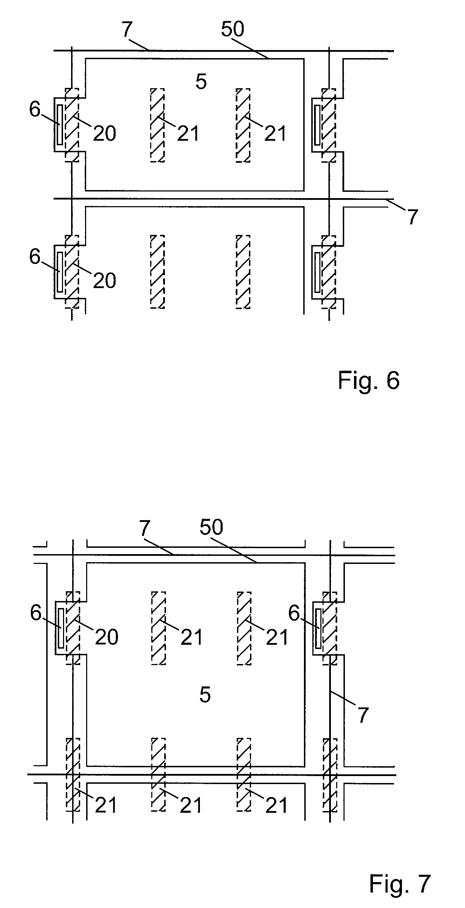

As can be seen by comparing the Figures 5 to 7, different layouts of sections can be fabricated with the same pattern of void areas. The layout illustrated in Figure 5 has approximately quadratic sections 5; half of the void areas 20 are used for isolating adjacent sections whereas the other half 21 remains unused. The layout of Figure 6 has more elongated sections; only one third of the void areas 20 are used. The sections shown in Figure 7 has quadratic cells with a bigger area than in Figure 5; each section covers 3,5 unused void areas 21 and uses a single void area 20 for isolating purposes. Other layouts of sections may be defined with the same configuration of void areas. It is even possible to combine different layouts on a same substrate.

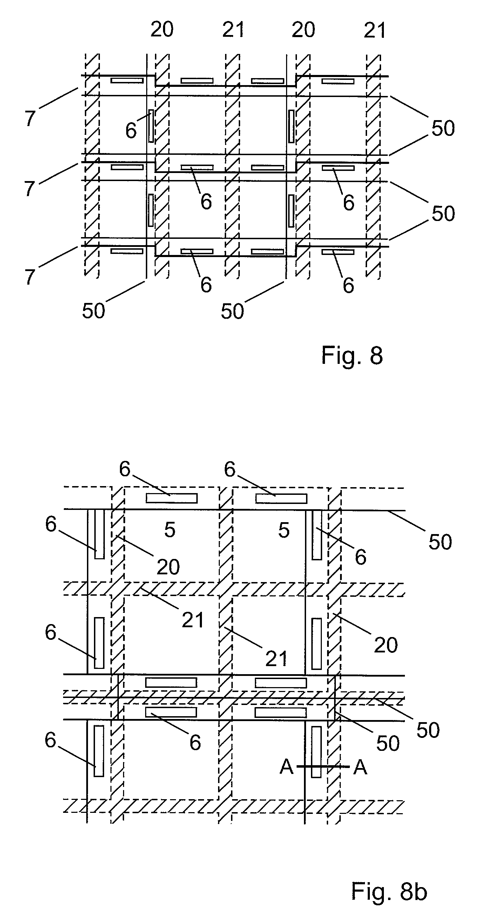

Figure 8 shows an example of a possible configuration of sections 5 which may be obtained from a semi-finished film with the pattern of void areas 20 shown in Figure 3. In this configuration, the sections 5 are rectangular and use two portions of two parallel neighbor conductive strips of the first conductive layer 2.

Figures 8b and 9 illustrate a possible configuration of sections 5 which may be obtained from a semi-finished film with the pattern of void areas 20 shown in Figure 4. In this example, the sections 5 are quadratic and cover four elementary portions of the first conductive layer 2. The post-processing method required to obtain this layout does not require any steps of isolating through the voltage-generating layer 3.Figure 10 shows how different layout of sections can be defined in a film comprising several voltage-generating layers 3, 30 by interconnecting the conductive layers 2, 4 and/or 40 and by isolating one or several layers.

The post-configuration process comprises a step of fixing a piece of semi-finished film of, for example, 30 cm x 30 cm area on an x-y table (not shown) by vacuum aspiration. Machining means (not shown), for example a YAG-laser, are fixed over the table. The table preferably comprises aligning means (not shown), for example an optical camera for detecting the position of the void areas 20, or the position of another reference on the film, in order to control the displacements and position of the machining means and to align the boundaries between sections with the void areas 20.

In one embodiment, the post-configuration process mainly comprises the following steps:
■ Establishing connections 6 through the voltage-producing layer 3 between the first and the second conductive layers 2, 4.
■ Defining the boundaries between individual sections 5 by cutting the second conductive layer 4 along lines 50.
■ Cutting and isolating all layers along lines 7.

All those three steps can be performed by laser scribing or laser welding. In a preferred embodiment, the displacements and operations of the laser over the semi-finished film are controlled by a computer (not shown) executing a computer program, which can be stored on a computer program storage product. Different patterns of lines 50, 6, 7 can be preprogrammed for specifying different configurations of sections in the film. Each pattern may include a set of trajectories along the x- and y-axis as well as parameters of the YAG-laser such as repetition rate, power, etc. The laser parameters are adjusted so that isolation of the second conductive layers, isolation of all layers 2, 3, 4 and/or an ohmic contact between the first and second conductive layers 2, 4 can be obtained. Additionally, the complete film, including the substrate, may be cut by the laser.

Alternatively, the connections 6 between the layers 2 and 4 can be made by scratching or by local application of a conductive material or by local application of electromagnetic energy or by a combination of these. The isolating lines 50 through the second conductive layer 4 can be performed by a lift-off process or by chemical etching. Cutting, milling, grinding or chemical etching operations may be performed in order to isolate adjacent portions of the first conductive layer 2 and of any superimposed layers along the lines 7.

After the post-configuration process, the resulting individual voltage-generating sections are tested and measured by a set of 2 contacts measuring the voltage and current of each module for a defined illumination. This process can be executed on the same table used for the post-configuration process. In this case, it is possible to laser-work each module according to its measured properties.

The post-processing operation may be used for defining the boundaries and mutual connections between portions of layers serving another purpose. For example, in a solar cell comprising antennas, the shape and/or interconnections between different sections of the antennas can be defined during this post-processing process.

In all the embodiments described so far, the discontinuities in the lower layer 2 are made of void areas which are either used for isolating adjacent sections, or unused. In a variant embodiment of the invention, the pattern of discontinuities in the first conductive layer 2 comprises prominent areas. A first part of those areas is used for interconnecting the first conductive layer 2 with the second conductive layer 4; the remaining prominent areas are not used. The one skilled in the art will understand that by selecting the prominent areas that are used for interconnecting purposes, it is possible to change the interconnection of sections during a post-configuration process.

Alternatively, it is possible to provide a first conductive layer with a pattern of discontinuities comprising both void areas and prominent portions. It is also possible to provide a film with the same or with different pattern of discontinuities of the same type and/or different types on different layers.

In all the embodiments described so far, the boundaries and interconnections between adjacent sections can only be defined by a post-configuration process requiring rather complicated or expensive equipments for cutting and interconnecting layers. Only the fabricant of voltage-generating films or important users will invest in such equipment. There is a need however for fabricating very limited series of voltage-generating cells customized to specific needs or applications, or even for customizing the layout and interconnection of sections after delivering to the end-user. It is therefore another object of the invention to provide a new solution for fulfilling this need.

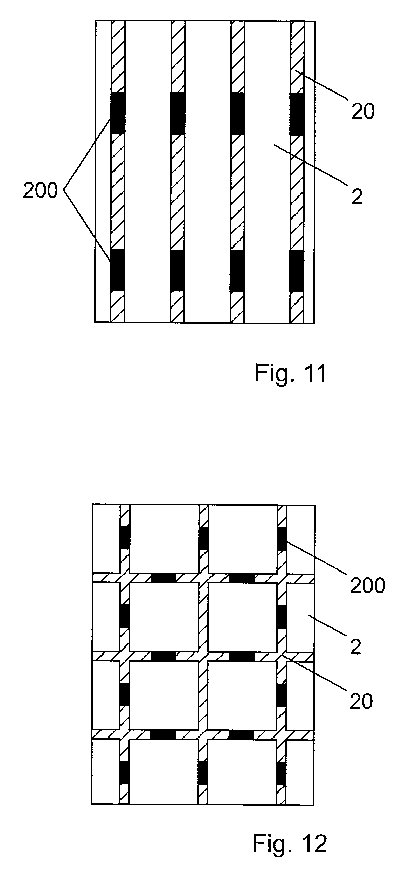

According to a further embodiment of the invention, in order to reach this object, at least one of the layers 2, 3, 4 in the film comprises a pattern of discontinuities comprising programmable switches 200. The switches may be connected between pre-isolated sections of at least one of the conductive layers 2 or 4, as shown in Figures 11 and 12. In those embodiments, the pattern of discontinuities comprises void areas, for example lines as shown in Figure 11 or a grid as shown in Figure 12, and a plurality of switches 200 for establishing or closing an ohmic connection between adjacent section on each side of the void areas 20.

Alternatively, switches may be provided between different layers, for example between the first and the second conductive layers 2, 4, and can be closed or maintained open to establish a connection between serially connected adjacent sections.

The switches 200 may be one-time programmable switches, for example fuses, which can be selectively burned during the post-configuration process with a laser, by selective application of ultra-violet light, heat or electricity on some switches, etc.

Alternatively, the switches 200 can be transistors, which can be opened or closed several times by application of a control voltage. This control voltage can be applied to the switches 200 through one or several supplementary control layers (not shown), for example through a control grid. This provides for a dynamic selection of the boundaries and interconnection between sections by controlling the voltage applied on each switch in the film.

A hardware and/or software driver may be provided for controlling the voltage applied to the switches in this configuration. By reconfiguring the sections, it is for example possible to provide a film delivering a constant voltage, or a constant current, or a suitable impedance, over a wide range of use. Alternatively, by controlling the switches fast enough, it is possible to produce an alternative voltage at the output of the film, and/or to modulate the output voltage with any modulating signal without any supplementary equipment.

Alternatively, by modulating the switches with the frequencies of 50 Hz or 60 Hz, or with multiples and phase-shifted components of 50 Hz or 60 Hz, three-phased AC power can be provided directly by the electric power-producing film.

## Claims

1. Electric power generating film including a plurality of mutually connected power-generating sections (5), said film comprising a plurality of superimposed layers (1, 2, 3, 4), at least one of said layers different from the upper layer comprising a regular pattern of discontinuities (20, 21),
**characterized in that** only a first part (20) of said discontinuities in said at least one layer (2) is used for defining the boundaries and/or connections between said sections, the remaining discontinuities (21) in said at least one layer being unused.

2. Electric power generating film according to claim 1, said layers comprising:
an isolating substrate (1),
a first conductive layer (2) extending over said substrate with the exception of said regular pattern of discontinuities (20, 21),
a voltage-developing layer (3) over said first conductive layer,
a second conductive layer (4) over said voltage-developing layer.

3. Electric power generating film according to claim 2, wherein said discontinuities comprise void areas (20, 21), only said first part (20) of said void areas being used for isolating adjacent sections (5).

4. Electric power generating film according to claim 3, wherein the number of void areas (20, 21) is higher than the number of sections (5).

5. Electric power generating film according to claim 3, wherein the remaining part (21) of said void areas causes a decrease of the power output of said film by increasing the electrical resistance of said first layer (2).

6. Electric power generating film according to claim 5, wherein said first part (20) of void areas is disposed adjacent to the border of said sections (5) whereas said remaining part (21) is not adjacent to said borders.

7. Electric power generating film according to claim 3, wherein said regular pattern of void areas (20, 21) comprises a plurality of individual void areas regularly spaced in two orthogonal directions.

8. Electric power generating film according to claim 3, wherein said regular pattern of void areas (20, 21) comprises parallel linear void areas extending each over the whole width of said substrate.

9. Electric power generating film according to claim 3, wherein said regular pattern of void areas (20, 21) consists of a grid of parallel and orthogonal linear void areas extending over the whole width of said film.

10. Electric power generating film according to one of the claims 1 or 2, wherein said discontinuities comprise prominent areas, only said first part of said prominent areas being used for interconnecting said first conductive layer (2) with said second conductive layer (4), the remaining part of said prominent areas remaining unused.

11. Electric power generating film according to one of the claims 1 or 2, wherein said discontinuities comprise programmable switches (200).

12. Electric power generating film according to claim 11, wherein said switches are one-time programmable switches.

13. Electric power generating film according to claim 12, wherein said one-time programmable switches are fuses.

14. Electric power generating film according to claim 11, wherein said switches are transistors.

15. Electric power generating film according to claim 14, further comprising at least one control layer comprising a plurality of conductive paths for electrically controlling said switches.

16. Electric power generating film according to one of the claims 11 to 15, wherein at least some of said switches are connected between adjacent sections.

17. Electric power generating film according to one of the claims 11 to 16, wherein at least some of said switches are connected between different conductive layers.

18. Electric power generating film according to one of the preceding claims, wherein said voltage-generating layer (3) comprises several silicon and silicon alloy sub-layers,
wherein said first and second conductive layers consist of metal or of conductive transparent oxide or of both,
and wherein said substrate consists of glass, of ceramic, or of polymer.

19. Electric power generating film according to one of the preceding claims, wherein said voltage-generating layer converts light into electricity.

20. Electric power generating film according to one of the claims 1 to 18, wherein said voltage-generating layer converts electromagnetic or ionizing radiation into electricity.

21. Electric power generating film according to one of the claims 1 to 18, wherein said voltage-generating layer converts a temperature gradient into electricity.

22. Electric power generating film according to one of the claims 1 to 18, wherein said voltage-generating layer converts chemical energy into electricity.

23. Semi-finished electric power generating film, comprising:
an isolating substrate (1),
a first conductive layer (2) extending over said substrate with the exception of a regular pattern of discontinuities (20, 21),
a voltage-developing layer (3) over said first conductive layer,
a second conductive layer (4) over said voltage-developing layer,
**characterized in that** said regular pattern of void areas comprises a plurality of individual void areas regularly spaced in two orthogonal directions.

24. Method of fabrication of electric power generating films including a plurality of power generating connected sections (5), comprising the following steps:
superimposing a plurality of layers (2, 3, 4) on a substrate (1), at least one of said layers different from the upper layer comprising a geometrical pattern of discontinuities (20, 21),
subsequently choosing only a part (21) of said discontinuities for defining the boundaries and/or connections between said sections.

25. Method according to claim 24, said step of superimposing layers comprising:
fabricating a first conducting layer (2) on said substrate (1) with said geometrical pattern of discontinuities (20, 21),
fabricating an active voltage-generating layer (3) on said first conductive layer,
fabricating a second conducting layer (4) on said active voltage-generating layer.

26. Method according to claim 25, wherein said discontinuities comprise void areas (20, 21), only said first part (20) of void areas being chosen for isolating adjacent sections (5).

27. Method according to one of the claims 25 or 26, wherein the boundaries and/or connections between said sections are defined by isolating said first conducting layer (2), said active voltage-generating layer (3) and said second conducting layer (4) to form a freely choseable arrangement of sections.

28. Method according to one of the claims 25 to 27, wherein the boundaries and/or connections between said sections are defined by isolating said second conducting layer (2).

29. Method according to one of the claims 25 to 28, wherein the boundaries and/or connections between said sections are defined by making a plurality of connections (6) between said first conducting layer (2) and said second conducting layer (4) through said active voltage-generating layer (3), in order to connect serially adjacent sections.

30. Method according to one of the claims 25 to 29,
wherein said discontinuities (20) comprise switches (200),
and wherein the boundaries and/or connections between said sections are defined by programming said switches..

31. Method for connecting and isolating sections in a semi-finished electric power generating film as claimed in claim 23, comprising:
isolating said first conducting layer (2), said active voltage-generating layer (3) and said second conducting layer (4) to form a freely choseable arrangement of sections (5), wherein only a part (21) of said void areas (20, 21) is used for isolating said sections.
